# EUROPÄISCHE PATENTSCHRIFT

(11) **EP 3 131 793 B1**
(45) Veröffentlichungstag und Bekanntmachung des Hinweises auf die Patenterteilung: **22.08.2018**
(21) Anmeldenummer: 15713440.4
(22) Anmeldetag: 26.03.2015
(51) Int. Cl.: B60R 21/017

(54) **VERFAHREN UND VORRICHTUNG ZUM ABSCHALTEN ZUMINDEST EINER ZÜNDENDSTUFE FÜR EINE ZÜNDPILLE EINES PYROTECHNISCHEN SCHUTZMITTELS FÜR EIN FAHRZEUG**
METHOD AND APPARATUS FOR DISCONNECTING AT LEAST ONE IGNITION OUTPUT STAGE FOR A FIRING CAP OF A PYROTECHNIC PROTECTION MEANS FOR A VEHICLE
PROCÉDÉ ET DISPOSITIF DE DÉSACTIVATION D'UN OU PLUSIEURS ÉTAGES D'ALLUMAGE D'UNE AMORCE D'UN MOYEN DE PROTECTION PYROTECHNIQUE POUR VÉHICULE

(30) Priorität: 16.04.2014 DE 102014207302
(43) Veröffentlichungstag der Anmeldung: 22.02.2017
(73) Patentinhaber: Robert Bosch GmbH, 70442 Stuttgart (DE)
(72) Erfinder: KARNER, Ruediger, 70806 Kornwestheim (DE); SCHUMACHER, Hartmut, 71691 Freiberg (DE); JOUSSE, Alain, 70192 Stuttgart (DE); WALKER, Steffen, 72770 Reutlingen (DE)
(86) Internationale Anmeldenummer: PCT/EP2015/056568
(87) Internationale Veröffentlichungsnummer: WO 2015/158519

(56) Entgegenhaltungen:
- DE-A1-102008 044 405
- DE-T2- 60 306 111

## Beschreibung

### Stand der Technik

Die vorliegende Erfindung bezieht sich auf ein Verfahren zum Abschalten zumindest einer Zündendstufe für eine Zündpille eines pyrotechnischen Schutzmittels für ein Fahrzeug, auf eine entsprechende Vorrichtung zum Abschalten zumindest einer Zündendstufe für eine Zündpille eines pyrotechnischen Schutzmittels für ein Fahrzeug, auf eine Zündendstufenvorrichtung mit einer entsprechenden Vorrichtung sowie auf ein entsprechendes Computerprogrammprodukt.

Aus der DE 603 06 111 T2 ist ein Verfahren zum Verhindern des unbeabsichtigten oder verzögerten Auslösens eines Passagierschutzelements einer Sicherheitsvorrichtung in einem Verkehrsmittel oder Fahrzeug bekannt, wobei die Sicherheitsvorrichtung eine Explosivladung und einen Zünder zum Zünden der Explosivladung (6) aufweist, mit den Schritten:
- Erkennen des Endes eines Betriebszustandes des Verkehrsmittels oder Fahrzeugs, und
- automatisches Entschärfen der Zündung nach einer zeitlichen Verzögerung in Reaktion auf das Erkennen des Endes des Betriebszustandes des Verkehrsmittels oder Fahrzeugs;
sowie eine entsprechende Vorrichtung, ein entsprechendes Passierschutzsystem und Sicherheitssystem.

Zur Aktivierung der Zündpillen in pyrotechnischen Rückhaltesystemen wird vom Hersteller der Zündmittel zur Gewährleistung einer sicheren und zeitgenauen Zündung ein minimaler Stromfluss über eine bestimmte Zeitdauer gefordert. Um diesen Anforderungen gerecht zu werden, wird das Design der Schaltung so ausgelegt, dass sie unter Berücksichtigung aller Toleranzen die Forderungen erfüllt. Dies führt dazu, dass sowohl die Zeitdauer als auch der Strom wesentlich höher als gefordert gewählt wird. Daher werden beispielsweise die Leistungsendstufen, die die Bestromung der Zündmittel ermöglichen, wesentlich größer ausgelegt, als den Anforderungen entsprechend.

### Offenbarung der Erfindung

Vor diesem Hintergrund werden mit dem hier vorgestellten Ansatz ein Verfahren zum Abschalten zumindest einer Zündendstufe für eine Zündpille eines pyrotechnischen Schutzmittels für ein Fahrzeug, weiterhin eine Vorrichtung zum Abschalten zumindest einer Zündendstufe für eine Zündpille eines pyrotechnischen Schutzmittels für ein Fahrzeug, wobei die Vorrichtung dieses Verfahren verwendet, eine Zündendstufenvorrichtung mit einer Vorrichtung zum Abschalten zumindest einer Zündendstufe für eine Zündpille eines pyrotechnischen Schutzmittels für ein Fahrzeug sowie schließlich ein entsprechendes Computerprogrammprodukt gemäß den Hauptansprüchen vorgestellt. Vorteilhafte Ausgestaltungen ergeben sich aus den jeweiligen Unteransprüchen und der nachfolgenden Beschreibung.

Elektrische und elektronische Bauelemente unterliegen Toleranzen. Eine Zündendstufe für eine Zündpille kann vorteilhaft kleiner ausgelegt werden, wenn trotz Toleranzen der eingesetzten Bauelemente auch ohne eine Überdimensionierung der Bauelemente beziehungsweise einer Schaltung zum Ansteuern der Zündpille ein minimaler Stromfluss, oder ein Stromfluss in einer Mindestgröße, über eine bestimmte Zeitdauer erzielt wird. So kann der geforderte minimale Stromfluss und die vorbestimmte Zeitdauer überwacht werden, und so eine Überlastung einzelner Bauelemente indirekt abgewendet werden.

Es wird ein Verfahren vorgestellt zum Abschalten zumindest einer Zündendstufe für eine Zündpille für ein pyrotechnisches Schutzmittel für ein Fahrzeug, wobei das Verfahren die folgenden Schritte aufweist:
Setzen eines Aktivierungssignals auf einen Aktivierungspegel, wenn eine Stromstärke eines Ansteuerstroms für die Zündendstufe einen vorabdefinierten Stromschwellenwert übersteigt;
Bestimmen einer Zeitdauer, in der das Aktivierungssignal auf den Aktivierungspegel gesetzt ist; und
Bereitstellen eines Schaltsignals zum Abschalten der Zündendstufe, abhängig von einem Vergleich der Zeitdauer mit einer vorabdefinierten Mindeststromflussdauer.

Unter einem pyrotechnischen Schutzmittel für ein Fahrzeug kann ein Rückhaltemittel wie beispielsweise ein Airbag oder ein Anschnallgurt, verstanden werden. Unter einer Zündendstufe kann eine Leistungsendstufe mit zumindest einem Transistor verstanden werden. Dabei kann zum Ansteuern des pyrotechnischen Schutzmittels eine Zündendstufe vorgesehen sein. Das Aktivierungssignal kann zwei Signalpegel vorsehen. Der vordefinierte Stromschwellenwert kann einen durch die Zündpille definierten minimalen Stromfluss repräsentieren. Dabei kann der minimale Stromfluss eine Minimalanforderung für eine Stromstärke darstellen, die zum Auslösen oder zum korrekten Ansteuern der Zündpille notwendig ist. Die vorabdefinierte Mindeststromflussdauer kann eine Minimalanforderung für eine Zeitdauer zum korrekten Ansteuern der Zündpille repräsentieren. Vorteilhaft kann durch das vorgestellte Verfahren die Zündendstufe abgeschaltet werden, sobald durch die Zündstufe ein geforderter Mindeststrom für eine geforderte Mindeststromflussdauer zum Ansteuern der Zündpille bereitgestellt wurde. Vorteilhaft kann eine optimale Auslegung der Endstufe erzielt bzw. umgesetzt werden und somit eine Kostenersparnis erzielt werden.

Ferner kann im Schritt des Bestimmens die Zeitdauer unter Verwendung eines Zählers bestimmt werden. Dabei kann ein Zählerstand des Zählers die Zeitdauer repräsentieren. Der Zähler kann ansprechend auf das Aktivierungssignal den Zählerstand inkrementieren. Im Schritt des Bestimmens kann die Zeitdauer unter Verwendung eines Zeitgebers bestimmt werden. Der Zeitgeber kann ausgebildet sein, ansprechend auf das Aktivierungssignal in einem vorab definierten Zeitintervall den Zähler zu implementieren. Auch durch diese Ausführungsform kann kostengünstig die Zeitdauer bestimmt werden, in der die Stromstärke des Ansteuerstroms größer dem Stromschwellenwert ist.

Im Schritt des Bereitstellens kann die Zeitdauer und ergänzend oder alternativ der Zählerstand mit einem vorabdefinierten Schwellenwert verglichen werden. Der Schwellenwert kann die Mindeststromflussdauer repräsentieren. Zum Ansteuern der Zündpille kann eine Mindeststromflussdauer definiert sein. Der Zählerstand kann zum Bestimmen der Mindeststromflussdauer mit einem Schwellenwert verglichen werden. So kann einfach und kostengünstig ein Einhalten der Mindeststromflussdauer überwacht werden.

Im Schritt des Setzens kann die Stromstärke unter Verwendung eines Stromwandlers bestimmt werden. Die Stromstärke des Ansteuerstroms kann mit einem Stromwandler bzw. einem Strommesser erfasst oder bestimmt werden. Vorteilhaft kann die Stromstärke ohne eine Veränderung des Ansteuerstroms bestimmt werden.

Ferner kann im Schritt des Setzens die Stromstärke mit einem den Stromschwellenwert repräsentierenden Schwellenstrom unter Verwendung eines Komparators verglichen werden. Um zu bestimmen, dass der Ansteuerstrom einen geforderten Mindeststrom bzw. zumindest den Stromschwellenwert zum Ansteuern der Zündpille aufweist, kann kostengünstig mit einem Komparator die Stromstärke mit dem Stromschwellenwert verglichen werden.

Optional kann mit einem dem Schritt des Setzens vorausgehenden Schritt des Erfassens die Stromstärke erfasst werden. Insbesondere kann die Stromstärke unter Verwendung eines Stromwandlers erfasst werden. So kann die Stromstärke in dem Schritt des Erfassens mit einem Stromwandler erfasst werden.

Das Verfahren kann einen Schritt des Ansteuerns einer Zündendstufe ansprechend auf das Schaltsignal umfassen. Dabei kann die Zündendstufe zumindest einen Transistor, insbesondere einen MOSFET-Transistor umfassen.

In dem Schritt des Ansteuerns kann die Zündendstufe ansprechend auf das Schaltsignal angesteuert werden. Die Zündendstufe kann einen Schalter umfassen. In einer Ausführungsform kann die Zündendstufe einen High-Side-Schalter und einen Low-Side-Schalter zum Steuern des Ansteuerstroms aufweisen.
Es wird eine Vorrichtung zum Abschalten zumindest einer Zündendstufe für eine Zündpille eines pyrotechnischen Schutzmittels für ein Fahrzeug vorgestellt, wobei die Vorrichtung die folgenden Merkmale aufweist:
eine Setzeinrichtung zum Setzen eines Aktivierungssignals auf einen Aktivierungspegel, wenn eine Stromstärke eines Ansteuerstroms für die Zündendstufe einen vorabdefinierten Stromschwellenwert übersteigt, wobei die Setzeinrichtung einen Stromwandler und einen Komparator umfasst; eine Bestimmeinrichtung zum Bestimmen einer Zeitdauer, in der das Aktivierungssignal auf den Aktivierungspegel gesetzt ist, wobei die Bestimmungseinrichtung einen Zähler und einen Zeitimpulsgeber umfasst; und
eine Schnittstelle zum Bereitstellen eines Schaltsignals zum Abschalten der Zündendstufe, abhängig von einem Vergleich der Zeitdauer mit einer vorabdefinierten Mindeststromflussdauer, wobei die Schnittstelle eine Vergleichseinrichtung umfasst, wobei der Stromwandler ausgebildet ist, den Ansteuerstrom zu erfassen und ein den Ansteuerstrom repräsentierendes Stromstärkesignal bereitzustellen, wobei der Komparator ausgebildet ist, das Aktivierungssignal auf den Aktivierungspegel zu setzen, wenn das Stromstärkesignal ein Stromschwellenwertsignal übersteigt, wobei ein Zählerstand des Zählers ansprechend auf das Aktivierungssignal und ein Signal des Zeitimpulsgebers inkrementiert wird und wobei die Vergleichseinrichtung ausgebildet ist, das Schaltsignal bereitzustellen, wenn der Zählerstand den Schwellenwert überschreitet.
Der hier vorgestellte Ansatz schafft eine Vorrichtung zum Abschalten zumindest einer Zündendstufe für eine Zündpille eines pyrotechnischen Schutzmittels für ein Fahrzeug, wobei die Vorrichtung ausgebildet ist, um die Schritte einer Variante eines hier vorgestellten Verfahrens in entsprechenden Einrichtungen durchzuführen bzw. umzusetzen. Auch durch diese Ausführungsvariante der Erfindung in Form einer Vorrichtung kann die der Erfindung zugrunde liegende Aufgabe schnell und effizient gelöst werden.
Unter einer Vorrichtung kann vorliegend ein elektrisches Gerät verstanden werden, das Sensorsignale verarbeitet und in Abhängigkeit davon Steuer- und/oder Datensignale ausgibt. Die Vorrichtung kann eine Schnittstelle aufweisen, die hard- und/oder softwaremäßig ausgebildet sein kann. Bei einer hardwaremäßigen Ausbildung können die Schnittstellen beispielsweise Teil eines sogenannten System-ASICs sein, der verschiedenste Funktionen der Vorrichtung beinhaltet. Es ist jedoch auch möglich, dass die Schnittstellen eigene, integrierte Schaltkreise sind oder zumindest teilweise aus diskreten Bauelementen bestehen. Bei einer softwaremäßigen Ausbildung können die Schnittstellen Softwaremodule sein, die beispielsweise auf einem Mikrocontroller neben anderen Softwaremodulen vorhanden sind.

Der hier vorgestellte Ansatz schafft eine Zündendstufenvorrichtung mit einer Zündendstufe und einer Variante einer hier vorgestellten Vorrichtung zum Abschalten zumindest einer Zündendstufe für eine Zündpille eines pyrotechnischen Schutzmittels für ein Fahrzeug. Die Zündendstufe umfasst einen High-Side-Schalter und einen Low-Side-Schalter zum Steuern eines Ansteuerstroms und umfasst weiterhin eine Schnittstelle zum Bereitstellen des Ansteuerstroms an die Zündpille für das pyrotechnische Schutzmittel. Die Schnittstelle der Vorrichtung ist ausgebildet, um das Schaltsignal als Steuersignal für zumindest einen der Schalter bereitzustellen.
Von Vorteil ist auch ein Computerprogrammprodukt oder Computerprogramm mit Programmcode, der auf einem maschinenlesbaren Träger oder Speichermedium wie einem Halbleiterspeicher, einem Festplattenspeicher oder einem optischen Speicher gespeichert sein kann und zur Durchführung, Umsetzung und/oder Ansteuerung der Schritte des Verfahrens nach einer der vorstehend beschriebenen Ausführungsformen verwendet wird, insbesondere wenn das Programmprodukt oder Programm auf einem Computer oder einer Vorrichtung ausgeführt wird.

Der hier vorgestellte Ansatz wird nachstehend anhand der beigefügten Zeichnungen beispielhaft näher erläutert. Es zeigen:
Fig. 1 ein Fahrzeug mit einer Vorrichtung zum Abschalten zumindest einer Zündendstufe gemäß einem Ausführungsbeispiel der vorliegenden Erfindung.
Fig. 2 ein Blockschaltbild einer Vorrichtung zum Abschalten zumindest einer Zündendstufe für eine Zündpille eines pyrotechnischen Schutzmittels für ein Fahrzeug gemäß einem Ausführungsbeispiel der vorliegenden Erfindung;
Fig. 3 ein Blockschaltbild einer Vorrichtung zum Abschalten zumindest einer Zündendstufe für eine Zündpille gemäß einem Ausführungsbeispiel der vorliegenden Erfindung;
Fig. 4 einen Schaltplan einer Zündendstufenvorrichtung mit einer Zündendstufe für eine Zündpille und mit einer Vorrichtung zum Abschalten der Zündendstufe gemäß einem Ausführungsbeispiel der vorliegenden Erfindung; und
Fig. 5 ein Ablaufdiagramm eines Verfahrens zum Abschalten zumindest einer Zündendstufe für eine Zündpille eines pyrotechnischen Schutzmittels für ein Fahrzeug gemäß einem Ausführungsbeispiel der vorliegenden Erfindung.

In der nachfolgenden Beschreibung günstiger Ausführungsbeispiele der vorliegenden Erfindung werden für die in den verschiedenen Figuren dargestellten und ähnlich wirkenden Elemente gleiche oder ähnliche Bezugszeichen verwendet, wobei auf eine wiederholte Beschreibung dieser Elemente verzichtet wird.

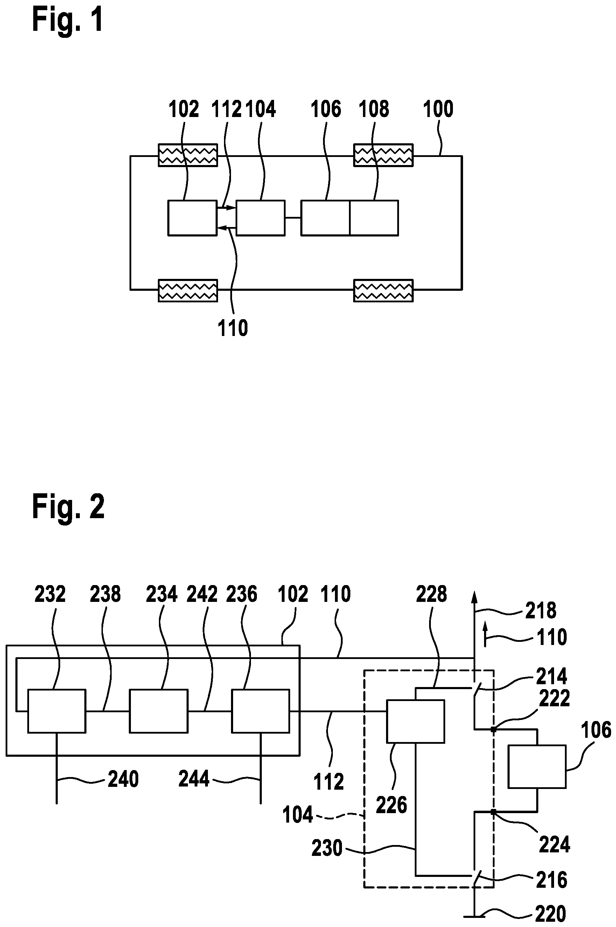

Fig. 1 zeigt ein Fahrzeug 100 mit einer Vorrichtung 102 zum Abschalten zumindest einer Zündendstufe 104 für eine Zündpille 106 eines pyrotechnischen Schutzmittels 108 gemäß einem Ausführungsbeispiel der vorliegenden Erfindung. Das Fahrzeug 100 umfasst das Schutzmittel 108. Dabei handelt es sich je nach Ausführungsbeispiel bei dem Schutzmittel 108 um ein Rückhaltemittel wie beispielsweise ein Airbag oder ein Gurtstraffer oder ein anderes pyrotechnisch auslösbares Schutzmittel 108, welches über die Zündpille 106 ausgelöst wird. Die Zündpille 106 wird durch einen entsprechenden Ansteuerstrom 110 gezündet. Für den Ansteuerstrom gelten gewisse Minimalanforderungen, wie eine Mindeststromstärke und eine Mindeststromflussdauer, die zum Zünden der Zündpille 106 zu erfüllen sind.

Die Vorrichtung 102 ist ausgebildet, den Ansteuerstrom 110 zu überwachen und ein Schaltsignal 112 bereitzustellen, um die Zündendstufe 104 abzuschalten, wenn die Minimalanforderungen an den Ansteuerstrom zum Zünden der Zündpille 106 erfüllt sind.

Ein Aspekt des vorlegenden Ausführungsbeispiels ist eine Abschaltung von Zündendstufen 104 in Airbagsteuergeräten in Abhängigkeit der Stromflussdauer durch die Zündpille 106. In dem in Fig. 1 dargestellten Ausführungsbeispiel ist eine Zündendstufe 104 mit eigenständiger Abschaltung 102 dargestellt.

Fig. 2 zeigt ein Blockschaltbild einer Vorrichtung 102 zum Abschalten zumindest einer Zündendstufe für eine Zündpille eines pyrotechnischen Schutzmittels für ein Fahrzeug gemäß einem Ausführungsbeispiel der vorliegenden Erfindung. Bei dem Fahrzeug kann es sich um ein Ausführungsbeispiel eines in Fig. 1 gezeigten Fahrzeugs 100 handeln. Somit kann es sich bei der Zündendstufe sowie der Zündpille um Ausführungsbeispiele der in Fig. 1 gezeigten Zündendstufe 104 und Zündpille 106 handeln.

Die Zündendstufe 104 umfasst gemäß diesem Ausführungsbeispiel einen ersten Schalter 214, einen zweiten Schalter 216 sowie zwei Anschlüsse 222, 224 zum Anschließen der Zündpille 106. Die zwei Schalter 214, 216 sind in einer Serienschaltung zwischen einem ersten Potenzialanschluss 218, beispielsweise einer Spannungsquelle, und einem zweiten Potenzialanschluss 220, beispielsweise einem Masseanschluss, geschaltet. Wenn die Schalter 214, 216 geschlossen sind, kann der Ansteuerstrom 110 über die Schalter 214, 216 sowie die an den Anschlüssen 222, 224 angeschlossene Zündpille 106 fließen und dadurch ein Zünden der Zündpille 106 bewirken.

In dem gezeigten Ausführungsbeispiel umfasst die Zündendstufe 104 eine Ansteuereinrichtung 226 zum Ansteuern der beiden Schalter 214, 216 ansprechend auf das Schaltsignal 112. Dabei ist die Ansteuereinrichtung 226 ausgebildet, das Schaltsignal 112 zu empfangen und in entsprechende Steuersignale 228, 230 umzusetzen. Dabei steuert das Steuersignal 228 den ersten Schalter 214 und das Steuersignal 230 den zweiten Schalter 216.

In einem nicht gezeigten Ausführungsbeispiel weist die Zündendstufe 104 nur einen Schalter auf, beispielsweise den ersten Schalter 214 oder alternativ den zweiten Schalter 216. In einem Ausführungsbeispiel wird das Schaltsignal 112 direkt an den Schalter 214, den Schalter 216 oder alternativ die beiden Schalter 214, 216 geleitet. In dem Fall umfasst die Zündendstufe 104 keine Ansteuereinrichtung 226.

Auch bei der Vorrichtung 102 kann es sich um ein Ausführungsbeispiel einer in Fig. 1 gezeigten Vorrichtung 102 zum Abschalten einer Zündendstufe 104 für eine Zündpille 106 eines pyrotechnischen Schutzmittels für ein Fahrzeug handeln. Die Vorrichtung 102 umfasst eine Setzeinrichtung 232, eine Bestimmeinrichtung 234 und eine Schnittstelle 236. Die Setzeinrichtung 232 ist ausgebildet ein Aktivierungssignal 238 auf einen Aktivierungspegel zusetzen, wenn eine Stromstärke des Ansteuerstroms 110 für die Zündendstufe einen vorab definierten Stromschwellenwert 240 übersteigt. In einem Ausführungsbeispiel umfasst die Setzeinrichtung 232 eine Strommessung beziehungsweise ein hier nicht dargestelltes Strommessgerät. Hierzu kann in die Zuleitung zwischen dem ersten Potenzialanschluss 218 und der Zündendstufe 104 ein Messwiderstand eingefügt werden oder beispielsweise eine Messspule angeordnet werden. Die Bestimmeinrichtung 234 ist ausgebildet zum Bestimmen einer Zeitdauer 242, in der das Aktivierungssignal 238 auf den Aktivierungspegel gesetzt ist. Das Bestimmen der Zeitdauer 242 erfolgt unter Verwendung des Aktivierungssignals 238. Die Schnittstelle 236 ist ausgebildet, das Schaltsignal 112 zum Abschalten der Zündendstufe 104 bereitzustellen. Dabei wird das Schaltsignal 112 abhängig von einem Vergleich der Zeitdauer 242 mit einer vorabdefinierten Mindeststromflussdauer 244 bereitgestellt.

Das hier vorgestellte Ausführungsbeispiel einer Vorrichtung 102 erlaubt beim Design der Zündendstufen 104 und ihrer Ansteuerung, durch die sichere Erfüllung der Minimalanforderung des Zündpillenherstellers, eine optimale Auslegung der Endstufen 104 und damit eine Kostenersparnis. Dabei ist ein Aspekt des vorgestellten Ausführungsbeispiels, dass die Zeitdauer, in der der geforderte Mindeststrom fließt, gemessen oder bestimmt wird und bei Erreichen der geforderten Mindeststromflussdauer die Leistungsendstufen 104 eigenständig ausgeschalten werden. Durch die Minimierung der Aktivierungszeit der Endstufen ist die Verlustleistung über diesen Baugruppen wesentlich kleiner. Dadurch wiederum kann die Baugruppe auch flächenmäßig kleiner ausgeführt werden, was zu einer Kostenreduzierung führt.

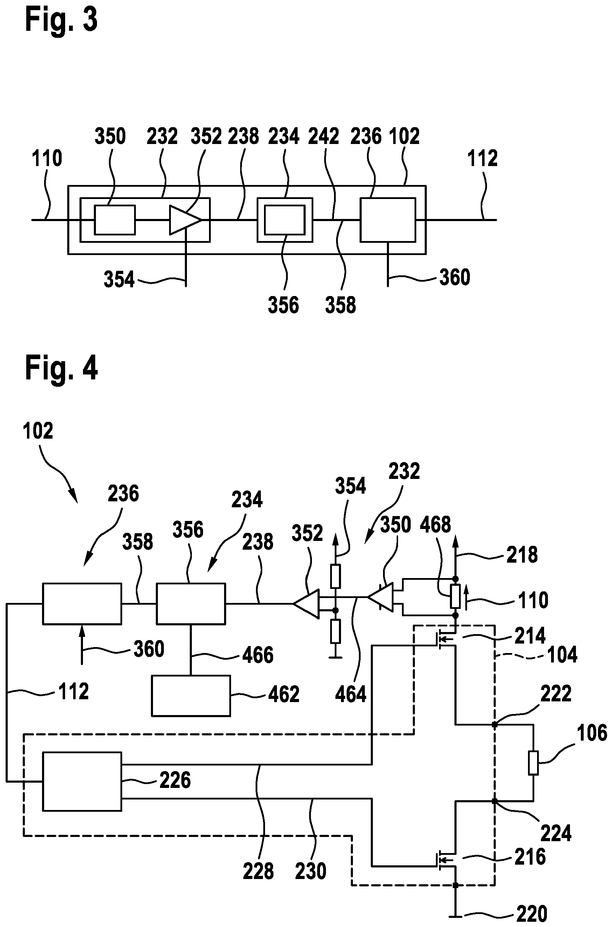

Fig. 3 zeigt ein Blockschaltbild einer Vorrichtung 102 zum Abschalten zumindest einer Zündendstufe für eine Zündpille eines pyrotechnischen Schutzmittels für ein Fahrzeug gemäß einem Ausführungsbeispiel der vorliegenden Erfindung. Bei der Vorrichtung 102 kann es sich um ein Ausführungsbeispiel einer in Fig. 1 oder Fig. 2 beschriebenen Vorrichtung 102 handeln. Die Vorrichtung 102 umfasst eine Setzeinrichtung 232, eine Bestimmeinrichtung 234 und eine Schnittstelle 236. Die Setzeinrichtung 232 ist ausgebildet, einen Ansteuerstrom 110 einzulesen oder alternativ zu erfassen. Die Schnittstelle 236 ist ausgebildet, durch ein entsprechendes Schaltsignal 112 die Zündendstufe für die Zündpille abzuschalten.

In dem gezeigten Ausführungsbeispiel weist die Setzeinrichtung 232 einen Stromwandler 350 und einen Komparator 352 auf. Der Stromwandler 350 ist ausgebildet, eine Stromstärke des Ansteuerstroms 110 zu bestimmen. Dabei handelt es sich in einem Ausführungsbeispiel bei dem Stromwandler 350 um einen Strommesser 350 oder ein anderes geeignetes Messgerät zum Erfassen der Stromstärke des Ansteuerstroms 110. Der Komparator 352 ist ausgebildet, die von dem Stromwandler 350 erfasste Stromstärke mit einem einen Stromschwellenwert repräsentierenden Schwellenstrom 354 oder Stromschwellenwertsignal 354 unter Verwendung des Komparators 352 zu vergleichen.

Die Bestimmeinrichtung 234 umfasst einen Zähler 356, der ausgebildet ist, die Zeitdauer zu bestimmen, in der das Aktivierungssignal 238 auf den Aktivierungspegel gesetzt ist. Dabei repräsentiert ein Zählerstand 358 des Zählers 356 die Zeitdauer 242.

Weiterhin ist die Schnittstelle 236 ausgebildet, die Zeitdauer 242 bzw. den die Zeitdauer 242 repräsentierenden Zählerstand 358 mit einem vorabdefinierten Schwellenwert 360 zu vergleichen. Dabei repräsentiert der Schwellenwert 360 eine Mindeststromflussdauer zum Zünden der Zündpille. Die Schnittstelle 236 ist ausgebildet, das Schaltsignal 112 bereitzustellen, wenn die Zeitdauer 242 zumindest den Wert der Mindeststromflussdauer aufweist.

In einem nicht gezeigten Ausführungsbeispiel umfasst die Vorrichtung 102 eine Ansteuereinrichtung zum Ansteuern zumindest einer Zündendstufe ansprechend auf das Schaltsignal 112. Eine Variante der Ansteuereinrichtung ist in Fig. 4 gezeigt und mit dem Bezugszeichen 226 versehen.

In einem Ausführungsbeispiel umfasst die Zündendstufe zumindest einen MOSFET-Transistor, insbesondere einen MOSFET-Transistor zum Einschalten und Ausschalten des Ansteuerstroms 110.

Fig. 4 zeigt einen Schaltplan einer Zündendstufenvorrichtung mit einer Zündendstufe 104 für eine Zündpille 106 und mit einer Vorrichtung 102 zum Abschalten der Zündendstufe 104 gemäß einem Ausführungsbeispiel der vorliegenden Erfindung.

Bei der Vorrichtung 102 kann es sich um ein Ausführungsbeispiel einer in Fig. 1 bis Fig. 3 beschriebenen Vorrichtung 102 handeln. Die Vorrichtung 102 umfasst eine Setzeinrichtung 232, eine Bestimmeinrichtung 234 und eine Schnittstelle 236. Die Setzeinrichtung 232 weist einen Stromwandler 350 sowie einen Komparator 352 auf. Die Bestimmeinrichtung 234 weist einen Zähler 356 sowie einen Zeitimpulsgeber 462 auf. Die Schnittstelle 236 weist eine Vergleichseinrichtung auf. Der Stromwandler 350 ist ausgebildet, den Ansteuerstrom 110 zu erfassen und als ein den Ansteuerstrom repräsentierendes Stromstärkesignal 464 dem Komparator 352 bereitzustellen. Der Komparator 352 ist ausgebildet, das Stromstärkesignal 464 mit einem Stromschwellenwertsignal 354 oder Schwellenstrom 354 zu vergleichen und das Aktivierungssignal 238 auf den Aktivierungspegel zu setzen, wenn das Stromstärkesignal 464 das Stromschwellenwertsignal 354 übersteigt.

Ein Zählerstand 358 des Zählers 356 wird ansprechend auf das Aktivierungssignal 238 und ein Signal 466 des Zeitimpulsgebers 462 inkrementiert. Die Vergleichseinrichtung der Schnittstelle 236 ist ausgebildet, das Schaltsignal 112 bereitzustellen, wenn der Zählerstand 358 den Schwellenwert 360 überschreitet.

An einem Anschluss der Vorrichtung 102 ist ein Ansteuerstrom 110 einleitbar oder messbar. Der Anschluss der Vorrichtung 102 ist gemäß diesem Ausführungsbeispiel über einen Messwiderstand 468 des Stromwandlers 350 bzw. des Strommessers 350 mit einer Leitung zum Leiten des Ansteuerstroms 110 durch die Zündendstufe 104 gekoppelt. Der Messwiderstand 468 ist dabei an einer geeigneten Position innerhalb der Leitung zum Leiten des Ansteuerstroms 110 angeordnet. In einem nicht gezeigten Ausführungsbeispiel ist der Anschluss der Vorrichtung 102 über eine Messspule des Strommessers 350 mit der Leitung zum Leiten des Ansteuerstroms 110 durch die Zündendstufe 104 gekoppelt. Die Messspule ist dabei an einer geeigneten Position innerhalb der Leitung zum Leiten des Ansteuerstroms 110 angeordnet.

Der Anschluss 218 wird auch als "High_out" bezeichnet, der Anschluss 220 wird auch als "Low_out" bezeichnet.

Der erste Schalter 214 wird auch als Highside-Schalter oder T1 bezeichnet. Der zweite Schalter 216 wird auch als Lowside-Schalter oder T2 bezeichnet. In einem Ausführungsbeispiel sind die beiden Schalter 214, 216 als Transistoren, insbesondere als MOSFET Transistoren, beispielsweise als N-Kanal MOSFET, ausgeführt. Der erste Schalter 214 ist beispielhaft zwischen dem Anschluss 218, auch als High_out" bezeichnet, und dem Anschluss der Vorrichtung 102 zum Erfassen des Ansteuerstroms 110 angeordnet. Der zweite Schalter 216 ist zwischen dem auch als "Low_out" bezeichneten Anschluss 220 und einem Masseanschluss angeordnet.

Die Zündendstufe 104 weist in dem in Fig. 4 gezeigten Ausführungsbeispiel einen Anschluss für das Steuersignal 112 auf. Eine Leitung für das Steuersignal 110 ist mit einer Ansteuereinrichtung 226 verbunden. Die Ansteuereinrichtung stellt an zwei Ausgängen Steuersignale 228, 230 bereit, die über entsprechende Leitungen an die entsprechenden Schalter 214, 216 geleitet werden.

Ein Ausgang des Stromwandlers 350, an dem das Stromstärkesignal 464 anliegt, ist mit einem Eingang des Komparators 352 verbunden. Ein weiterer Eingang des Komparators 352 ist über einen ersten Komparatorwiderstand mit einem Anschluss für das Stromschwellenwertsignal 354 und über einen zweiten Komparatorwiderstand mit Masse verbunden. Am Ausgang des Komparators 352 liegt das Aktivierungssignal 238 an. Der Ausgang des Komparators 352 ist mit einem Eingang des Zählers 356 verbunden. Ein Impulsgeber 462 stellt ein Signal 466 bereit. Der Zähler 356 ist ausgebildet, unter Verwendung des Signals 466 des Impulsgebers 462 und dem Aktivierungssignal 238 einen Zählerstand 358 zu inkrementieren. Der Zähler 356 ist mit der Schnittstelle 236 verbunden. Die Schnittstelle 236 ist ausgebildet, das Schaltsignal 112 bereitzustellen, wobei das Schaltsignal 112 ausgegeben wird, wenn der Zählerstand 358 den Schwellenwert 360 erreicht oder alternativ übersteigt. Die Schnittstelle 236 ist mit der Ansteuereinrichtung 226 verbunden. Die Ansteuereinrichtung 226 ist ausgebildet, die Zündendstufe 104 ansprechend auf das Schaltsignal 112 anzusteuern. Die Ansteuereinrichtung 226 ist über einen Anschluss der Zündstufe 104 mit dem ersten Schalter 214 sowie zusätzlich oder alternativ mit dem zweiten Schalter 216 verbunden.

Der Strom 110, der über den ersten Schalter 214 (Transistor 1; T1), die Zündpille 106 und den zweiten Schalter 216 (Transistor 2; T2) nach Masse fließt, wird unter Verwendung der Vorrichtung 102 gemessen und der Wert dieses Ansteuerstroms 110 wird an den Komparator 352 geführt. Die Schwelle des Komparators 352 wird in Abhängigkeit des geforderten Zündstrom-Niveaus festgelegt. Solange der durch das Stromstärkesignal 464 angezeigte gemessene Strom 110 über der geforderten Schwelle 354 liegt, wird ein Zeitgeber 462 freigeschaltet, der in einem festgelegten Zeitintervall einen Zähler 356 inkrementiert. Hat dieser Zähler 356 den Zählerstand 358, der der geforderten Aktivierungszeit entspricht, erreicht, werden die beiden Schalter 214, 216 oder Endstufen (T1 und T2) ausgeschalten.

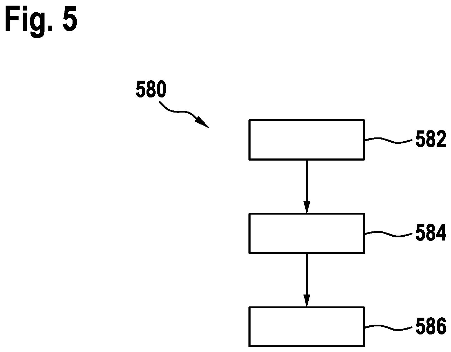

Fig. 5 zeigt ein Ablaufdiagramm eines Verfahrens 580 zum Abschalten zumindest einer Zündendstufe für eine Zündpille eines pyrotechnischen Schutzmittels für ein Fahrzeug gemäß einem Ausführungsbeispiel der vorliegenden Erfindung. Bei der Zündendstufe kann es sich um eine in Fig. 1 oder Fig. 4 gezeigte Zündendstufe 104 handeln. Das Verfahren 580 umfasst einen Schritt 582 des Setzens eines Aktivierungssignals, einen Schritt 584 des Bestimmens einer Zeitdauer sowie einen Schritt 586 des Bereitstellens eines Schaltsignals zum Abschalten der Zündendstufe. Im Schritt 582 des Setzens des Aktivierungssignals wird das Aktivierungssignal auf einen Aktivierungspegel gesetzt, wenn eine Stromstärke eines Ansteuerstroms für die Zündendstufe einen vorabdefinierten Stromschwellenwert übersteigt. Im Schritt 584 des Bestimmens einer Zeitdauer wird die Zeitdauer bestimmt, in der das Aktivierungssignal auf den Aktivierungspegel gesetzt ist. Im Schritt 586 des Bereitstellens wird ein Schaltsignal zum Abschalten der Zündendstufe bereitgestellt in Abhängigkeit von einem Vergleich der Zeitdauer mit einer vorabdefinierten Mindeststromflussdauer. In einem Ausführungsbeispiel wird das Schaltsignal bereitgestellt, wenn die Zeitdauer zumindest den Wert der vorabdefinierten Mindeststromflussdauer erreicht.

In einem Ausführungsbeispiel umfasst das Verfahren einen optionalen, hier nicht gezeigten, Schritt des Ansteuerns zumindest einer Zündendstufe und ergänzend oder alternativ einer weiteren Zündendstufe ansprechend auf das Schaltsignal.

Die beschriebenen und in den Figuren gezeigten Ausführungsbeispiele sind nur beispielhaft gewählt. Unterschiedliche Ausführungsbeispiele können vollständig oder in Bezug auf einzelne Merkmale miteinander kombiniert werden. Auch kann ein Ausführungsbeispiel durch Merkmale eines weiteren Ausführungsbeispiels ergänzt werden.

Ferner können die hier vorgestellten Verfahrensschritte wiederholt sowie in einer anderen als in der beschriebenen Reihenfolge ausgeführt werden.

Umfasst ein Ausführungsbeispiel eine "und/oder"-Verknüpfung zwischen einem ersten Merkmal und einem zweiten Merkmal, so ist dies so zu lesen, dass das Ausführungsbeispiel gemäß einer Ausführungsform sowohl das erste Merkmal als auch das zweite Merkmal und gemäß einer weiteren Ausführungsform entweder nur das erste Merkmal oder nur das zweite Merkmal aufweist.

## Patentansprüche

1. Verfahren (580) zum Abschalten zumindest einer Zündendstufe (104) für eine Zündpille (106) für ein pyrotechnisches Schutzmittel (108) für ein Fahrzeug (100), wobei das Verfahren (580) die folgenden Schritte aufweist:
Setzen (582) eines Aktivierungssignals (238) auf einen Aktivierungspegel, wenn eine Stromstärke (464) eines Ansteuerstroms (110) für die Zündendstufe (104) einen vorabdefinierten Stromschwellenwert (354) übersteigt;
Bestimmen (584) einer Zeitdauer (242), in der das Aktivierungssignal (238) auf den Aktivierungspegel gesetzt ist; und
Bereitstellen (586) eines Schaltsignals (112) zum Abschalten der Zündendstufe (104), abhängig von einem Vergleich der Zeitdauer (242) mit einer vorabdefinierten Mindeststromflussdauer (244).

2. Verfahren (580) gemäß Anspruch 1, bei dem im Schritt (584) des Bestimmens die Zeitdauer (242) unter Verwendung eines Zählers (356) bestimmt wird, wobei ein Zählerstand (358) des Zählers (356) die Zeitdauer (242) repräsentiert.

3. Verfahren (580) gemäß einem der vorangegangenen Ansprüche, bei dem im Schritt (586) des Bereitstellens die Zeitdauer (242) und/oder der Zählerstand (358) mit einem vorabdefinierten Schwellenwert (360) verglichen wird, wobei der Schwellenwert (360) die Mindeststromflussdauer (244) repräsentiert.

4. Verfahren (580) gemäß einem der vorangegangenen Ansprüche, bei dem im Schritt (582) des Setzens die Stromstärke (464) unter Verwendung eines Stromwandlers (350) bestimmt wird.

5. Verfahren (580) gemäß einem der vorangegangenen Ansprüche, bei dem im Schritt (582) des Setzens die Stromstärke (464) mit einem den Stromschwellenwert (354) repräsentierenden Schwellenstrom (354) unter Verwendung eines Komparators (352) verglichen wird.

6. Verfahren (580) gemäß einem der vorangegangenen Ansprüche, mit einem Schritt des Ansteuerns einer Zündendstufe (104) ansprechend auf das Schaltsignal (112).

7. Vorrichtung (102) zum Abschalten zumindest einer Zündendstufe (104) für eine Zündpille (106) eines pyrotechnischen Schutzmittels (108) für ein Fahrzeug (100), wobei die Vorrichtung (102) die folgenden Merkmale aufweist:
eine Setzeinrichtung (232) zum Setzen eines Aktivierungssignals (238) auf einen Aktivierungspegel, wenn eine Stromstärke (464) eines Ansteuerstroms (110) für die Zündendstufe (104) einen vorabdefinierten Stromschwellenwert (354) übersteigt, wobei die Setzeinrichtung (232) einen Stromwandler (350) und einen Komparator (352) umfasst;
eine Bestimmeinrichtung (234) zum Bestimmen einer Zeitdauer (242), in der das Aktivierungssignal (238) auf den Aktivierungspegel gesetzt ist, wobei die Bestimmeinrichtung (234) einen Zähler (356) und einen Zeitimpulsgeber (462) umfasst; und
eine Schnittstelle (236) zum Bereitstellen eines Schaltsignals (112) zum Abschalten der Zündendstufe (104), abhängig von einem Vergleich der Zeitdauer (242) mit einer vorabdefinierten Mindeststromflussdauer (244), wobei die Schnittstelle (236) eine Vergleichseinrichtung umfasst, wobei der Stromwandler (350) ausgebildet ist, den Ansteuerstrom (110) zu erfassen und ein den Ansteuerstrom (110) repräsentierendes Stromstärkesignal (464) bereitzustellen, wobei der Komparator (352) ausgebildet ist, das Aktivierungssignal (238) auf den Aktivierungspegel zu setzen, wenn das Stromstärkesignal (464) ein Stromschwellenwertsignal (354) übersteigt, wobei ein Zählerstand (358) des Zählers (356) ansprechend auf das Aktivierungssignal (238) und ein Signal (466) des Zeitimpulsgebers (462) inkrementiert wird und wobei die Vergleichseinrichtung ausgebildet ist, das Schaltsignal (112) bereitzustellen, wenn der Zählerstand (358) den Schwellenwert (360) überschreitet.

8. Zündendstufenvorrichtung mit folgenden Merkmalen:
einer Zündendstufe (104) mit einem High-Side-Schalter (214) und einem Low-Side-Schalter (216) zum Steuern eines Ansteuerstroms (110) und mit einer Schnittstelle zum Bereitstellen des Ansteuerstroms (110) an eine Zündpille (106) für ein pyrotechnisches Schutzmittel (108) für ein Fahrzeug (100); und
einer Vorrichtung (102) gemäß Anspruch 7, wobei die Schnittstelle (236) der Vorrichtung (102) ausgebildet ist, um das Schaltsignal (112) als Steuersignal für zumindest einen der Schalter (214, 216) bereitzustellen.

9. Computerprogramm, das dazu eingerichtet ist, alle Schritte eines Verfahrens (580) nach einem der Ansprüche 1 bis 6 durchzuführen.

10. Maschinenlesbares Speichermedium mit einem darauf gespeicherten Computerprogramm nach Anspruch 9.

## Claims

1. Method (580) for shutting down at least one ignition output stage (104) for an igniter (106) for a pyrotechnic protection means (108) for a vehicle (100), wherein the method (580) has the following steps:
setting (582) an activation signal (238) to an activation level if a current intensity (464) of an actuation current (110) for the ignition output stage (104) exceeds a previously defined current threshold value (354);
determining (584) a period (242) in which the activation signal (238) is set to the activation level; and
providing (586) a switching signal (112) for shutting down the ignition output stage (104), on the basis of a comparison of the period (242) with a previously defined minimum current flow time (244).

2. Method (580) according to Claim 1, in which the determination step (584) entails the period (242) being determined by using a counter (356), wherein a count (358) of the counter (356) represents the period (242).

3. Method (580) according to either of the preceding claims, in which the provision step (586) entails the period (242) and/or the count (358) being compared with a previously defined threshold value (360), wherein the threshold value (360) represents the minimum current flow time (244).

4. Method (580) according to one of the preceding claims, in which the setting step (582) entails the current intensity (464) being determined by using a current transformer (350).

5. Method (580) according to one of the preceding claims, in which the setting step (582) entails the current intensity (464) being compared with a threshold current (354) representing the current threshold value (354) by using a comparator (352).

6. Method (580) according to one of the preceding claims, having a step of actuating an ignition output stage (104) in response to the switching signal (112).

7. Apparatus (102) for shutting down at least one ignition output stage (104) for an igniter (106) of a pyrotechnic protection means (108) for a vehicle (100), wherein the apparatus (102) has the following features:
a setting device (232) for setting an activation signal (238) to an activation level if a current intensity (464) of an actuation current (110) for the ignition output stage (104) exceeds a previously defined current threshold value (354), wherein the setting device (232) comprises a current transformer (350) and a comparator (352) ;
a determining device (234) for determining a period (242) in which the activation signal (238) is set to the activation level, wherein the determining device (234) comprises a counter (356) and a time pulse transmitter (462); and
an interface (236) for providing a switching signal (112) for shutting down the ignition output stage (104), on the basis of a comparison of the period (242) with a previously defined minimum current flow time (244), wherein the interface (236) comprises a comparison device, wherein the current transformer (350) is configured to capture the actuation current (110) and to provide a current intensity signal (464) representing the actuation current (110), wherein the comparator (352) is configured to set the activation signal (238) to the activation level if the current intensity signal (464) exceeds a current threshold value signal (354), wherein a count (358) of the counter (356) is incremented in response to the activation signal (238) and a signal (466) from the time pulse transmitter (462) and wherein the comparison device is configured to provide the switching signal (112) if the count (358) exceeds the threshold value (360).

8. Ignition output stage apparatus having the following features:
an ignition output stage (104) having a high-side switch (214) and a low-side switch (216) for controlling an actuation current (110) and having an interface for providing the actuation current (110) to an igniter (106) for a pyrotechnic protection means (108) for a vehicle (100); and
an apparatus (102) according to Claim 7, wherein the interface (236) of the apparatus (102) is configured to provide the switching signal (112) as a control signal for at least one of the switches (214, 216).

9. Computer program set up to perform all the steps of a method (580) according to one of Claims 1 to 6.

10. Machine-readable storage medium having a computer program according to Claim 9 stored thereon.

## Revendications

1. Procédé (580), destiné à désactiver au moins un étage final d'allumage (104) d'une amorce (106) d'un moyen protecteur pyrotechnique (108) d'un véhicule (100), le procédé (580) comportant les étapes suivantes :
placement (582) d'un signal d'activation (238) à un niveau d'activation, si une intensité de courant (464) d'un courant d'amorçage (110) pour l'étage final d'allumage (104) dépasse une valeur seuil de courant (354) prédéfinie ;
détermination (584) d'une durée (242), pendant laquelle le signal d'activation (238) est placé au niveau d'activation ; et
mise à disposition (586) d'un signal de commutation (112) pour désactiver l'étage final d'allumage (104), en fonction d'une comparaison de la durée (242) avec une durée minimale de passage du courant (244) prédéfinie.

2. Procédé (580) selon la revendication 1, lors duquel, dans l'étape (584), on détermine la durée (242) en utilisant un compteur (356), une valeur de compteur (358) du compteur (356) représentant la durée (242).

3. Procédé (580) selon l'une quelconque des revendications précédentes, lors duquel dans l'étape (586) de la mise à disposition, on compare la durée (242) et/ou la valeur du compteur (358) avec une valeur seuil (360) prédéfinie, la valeur seuil (360) représentant la durée minimale de passage du courant (244).

4. Procédé (580) selon l'une quelconque des revendications précédentes, lors duquel, dans l'étape (582) du placement, on détermine l'intensité de courant (464) en utilisant un transformateur de courant (350).

5. Procédé (580) selon l'une quelconque des revendications précédentes, lors duquel, dans l'étape (582) du placement, on compare l'intensité du courant (464) avec un courant seuil (354) représentant la valeur seuil de courant (354) en utilisant un comparateur (352).

6. Procédé (580) selon l'une quelconque des revendications précédentes, avec une étape de l'amorçage d'un étage final d'allumage (104), en réponse au signal de commutation (112).

7. Dispositif (102) destiné à désactiver au moins un étage final d'allumage (104) d'une amorce (106) d'un moyen protecteur pyrotechnique (108) d'un véhicule (100), le dispositif (102) présentant les caractéristiques suivantes :
un système de placement (232), destiné à placer un signal d'activation (238) à un niveau d'activation, si une intensité de courant (464) d'un courant d'amorçage (110) pour l'étage final d'allumage (104) dépasse une valeur seuil de courant (354) prédéfinie, le dispositif de placement (232) comprenant un transformateur de courant (350) et un comparateur (352) ;
un système de détermination (234), destiné à déterminer une durée (242) pendant laquelle le signal d'activation (238) est placé sur le niveau d'activation, le système de détermination (234) comprenant un compteur (356) et un émetteur d'impulsions de temps (462) ; et
une interface (236) pour la mise à disposition d'un signal de commutation (112) destinée à désactiver l'étage final d'allumage (104) en fonction d'une comparaison de la durée (242) avec une durée minimale de passage du courant (244) prédéfinie, l'interface (236) comprenant un système de comparaison,
le transformateur de courant (350) est conçu pour détecter le courant d'amorçage (110) et pour mettre à disposition un signal d'intensité de courant (464) représentant le courant d'amorçage (110), le comparateur (352) étant conçu pour placer le signal d'activation (238) au niveau d'activation si le signal d'intensité de courant (464) dépasse un signal de valeur seuil de courant (354), une valeur de compteur (358) du compteur (356) en réponse au signal d'activation (238) et un signal (466) du transmetteur d'impulsions de temps (462) étant incrémentés, le système de comparaison étant conçu pour mettre à disposition le signal de commutation (112) si la valeur du compteur (358) dépasse la valeur seuil (360).

8. Dispositif d'étage final d'allumage, présentant les caractéristiques suivantes :
un étage final d'allumage (104) doté d'un interrupteur de côté haut (214) et d'un interrupteur de côté bas (216) pour commander un courant d'amorçage (110) et d'une interface pour mettre à disposition le courant d'amorçage (110) sur une amorce (106) d'un moyen protecteur pyrotechnique (108) d'un véhicule (100) ; et
un dispositif (102) selon la revendication 7, l'interface (236) du dispositif (102) étant conçue pour mettre à disposition le signal de commutation (112) en tant que signal de commande pour au moins l'un des interrupteurs (214, 216).

9. Programme informatique qui est aménagé pour réaliser toutes les étapes d'un procédé (580) selon l'une quelconque des revendications 1 à 6.

10. Support de mémoire lisible par machine, avec un programme informatique selon la revendication 9 qui y est mémorisé.
